(19) Europäisches Patentamt / European Patent Office / Office européen des brevets

(11) **EP 4 257 722 A1**

(12) **EUROPEAN PATENT APPLICATION**
published in accordance with Art. 153(4) EPC

(43) Date of publication:
**11.10.2023 Bulletin 2023/41**

(21) Application number: **21900466.0**

(22) Date of filing: **24.11.2021**

(51) International Patent Classification (IPC):
**C23C 14/24** (2006.01)    **B32B 9/00** (2006.01)
**C23C 14/08** (2006.01)

(52) Cooperative Patent Classification (CPC):
**B32B 9/00; C23C 14/08; C23C 14/24**

(86) International application number:
**PCT/JP2021/043002**

(87) International publication number:
**WO 2022/118711 (09.06.2022 Gazette 2022/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **02.12.2020  JP 2020200502**

(71) Applicant: **TOYOBO CO., LTD.**
**Osaka-shi**
**Osaka 5300001 (JP)**

(72) Inventor: **ISEKI, Kiyoshi**
**Inuyama-shi, Aichi 484-8508 (JP)**

(74) Representative: **Vossius & Partner**
**Patentanwälte Rechtsanwälte mbB**
**Siebertstraße 3**
**81675 München (DE)**

(54) **METHOD AND APPARATUS FOR PRODUCING TRANSPARENT GAS BARRIER FILM**

(57)    A method and apparatus for producing a long transparent barrier film, which has stable barrier properties and color by stably adjusting the degree of oxidation and the film thickness to desired values, comprises a step for producing a transparent gas barrier film which has, on at least one surface of a plastic film, an aluminum oxide layer that is mainly composed of aluminum oxide or a silicon oxide layer that is mainly composed of silicon oxide, said aluminum or silicon oxide layer being produced by evaporating aluminum metal or silicon metal and injecting oxygen thereinto. In this step, the film thickness of the thus-formed aluminum oxide layer or silicon oxide layer is measured by a film thickness gauge using X ray fluorescence and the light transmittance of the thus-formed aluminum oxide layer or silicon oxide layer is measured by a light transmittance measuring device so as to control the film thickness and the light transmittance to be at predetermined values.

EP 4 257 722 A1

**Description**

TECHNICAL FIELD

The present invention relates to method and apparatus for producing a transparent barrier film having excellent properties as a packaging material that has excellent transparency, gas barrier properties, printability, and flexibility and is required to provide the airtightness of foods, pharmaceuticals, and electronic components and the like, or a gas blocking material.

BACKGROUND ART

As a transparent barrier film, a plastic film obtained by laminating an inorganic substance on a plastic film is commercially available. As the inorganic substance, metal oxides such as silicon oxide and aluminum oxide are often used from the viewpoint of transparence. The metal oxide is mainly laminated on a plastic film by a vapor-deposition method or a CVD method.

In particular, a laminated film that includes, as a barrier layer, an aluminum oxide layer or a silicon oxide layer formed by a reactive vapor-deposition method of evaporating aluminum or silicon monoxide and introducing oxygen is mainly used (see, for example, Patent Document 1).

In the transparent barrier film in which an inorganic substance layer is laminated, a plastic film in which an inorganic layer is coated with the organic layer or the like to improve barrier properties or protect the inorganic layer is also commercially available (see, for example, Patent Document 2).

The transparent barrier film is used in a state where the film is subjected to printing when used for a packaging material, or other plastic film is laminated on the film using an adhesive or the like. Although various plastic films are laminated, an un-stretched polyethylene film or polypropylene film called a sealant is generally laminated in order to make a bag.

Barrier performance of the transparent barrier film produced by the reactive vapor-deposition method is affected by the film thickness and oxidation degree of the inorganic layer to be formed. If the film thickness is too thin, a uniform layer cannot be formed, and the barrier performance is insufficient. If the film thickness is extremely thin, the barrier performance is not exhibited. If the thickness is too large, the inorganic layer is likely to be broken when the plastic film is bent, and the barrier performance cannot be maintained. As described above, there is a suitable film thickness range for the aluminum oxide layer and the silicon oxide layer, and the film thickness range is a value to be managed.

Although a complete aluminum oxide is represented by $Al_2O_3$, the aluminum oxide layer produced by reactive vapor-deposition is expressed as AlOx (x = 0 to 1.5) or the like, and can take a state where oxygen is insufficient with respect to a complete oxide. Similarly, silicon oxide is $SiO_2$, but can take a state of insufficient oxidation expressed as SiOx or the like.

In an incomplete aluminum oxide layer, in a state of metal aluminum where metallic luster is lost and the color turns dark brown as oxidation progresses from metal aluminum, the incomplete aluminum oxide layer has barrier properties; however, the barrier properties are lost in a slightly oxidized state. As the oxidation further progresses, the color becomes lighter, transparency is obtained, and the barrier performance is obtained. In addition, when oxygen is blown to eliminate coloring, the barrier performance is deteriorated in the aluminum oxide layer produced by reactive vapor-deposition. Therefore, the aluminum oxide layer produced by reactive vapor-deposition has a suitable range of the oxidation degree, and is a value to be managed.

The same applies to silicon oxide.

Although the oxidation degree can be determined from the abundance ratio by determining a valence from a chemical shift using X-ray photoelectron spectroscopy (XPS), since it takes a lot of time and effort, light ray transmittance is generally used as an alternative index.

Therefore, in order to produce a transparent barrier film having a barrier layer by reactive vapor-deposition such as silicon oxide or aluminum oxide, it is preferable to produce the transparent barrier film while controlling the film thickness and the light ray transmittance.

However, it is common to produce a transparent barrier film while measuring only the light ray transmittance (see, for example, Patent Document 3).

A method of adjusting an evaporation amount with a constant amount of oxygen introduced into a vacuum apparatus will be described. The conditions of a target light ray transmittance and film thickness are obtained by variously changing an oxygen introduction amount, a plastic film traveling speed, and heating conditions of vapor-deposition material (metal aluminum, silicon material) using a producing apparatus. It is easy to set the oxygen introduction amount and the plastic film traveling speed to predetermined values by the apparatus, and thus, the oxygen introduction amount and the plastic film traveling speed are adjusted to the obtained conditions.

By measuring the light ray transmittance and heating an evaporation source so that the light ray transmittance matches a target value, a transparent barrier film having a target film thickness can be obtained.

That is, when the evaporation amount increases, the oxygen introduction amount per evaporation amount decreases, so that the oxidation degree decreases, and a light absorption coefficient of aluminum oxide increases. Since the plastic film traveling speed is constant, the film thickness to be deposited also increases. Therefore, since the light ray transmittance is lowered, it is possible to perform adjustment to lower heating and lower the evaporation amount. The same applies to the reverse case.

Therefore, in order to change the conditions and change the producing apparatus, trial production for determining the conditions again is required.

In a production method for producing a transparent barrier film, an induction heating method, a resistance heating method, and an electron beam heating method are mainly used as a method of heating an evaporation source. In the induction heating method and the electron beam heating method, even if heating is performed with the same electric power, an amount of vapor-deposition material and a state of heat insulation change, and the evaporation amount changes; therefore, it is necessary to control the evaporation amount to be constant.

In the resistance heating system, since a line of aluminum is fed to a boat-shaped heat generator made of conductive ceramic called a BN composite to evaporate, the evaporation amount can be estimated by an increase or decrease in a liquid of aluminum on the boat. That is, when the liquid is in a constant state, it can be said that the evaporation amount is equal to an amount of the aluminum line fed, so that the evaporation amount can be estimated.

Therefore, there is a production method in which the evaporation amount is constant, and the light ray transmittance can be adjusted by adjusting the oxygen introduction amount using a measurement value of a light ray transmittance monitor.

However, in a film thickness adjustment method in which the oxygen introduction amount is made constant in the production method of heating the vapor-deposition material by the resistance heating method, the induction heating method, or the electron beam heating method, it is assumed as a premise that the introduced oxygen is taken into the aluminum oxide layer at a constant ratio and there is no gas that oxidizes aluminum metal other than the introduced oxygen. However, when pressure in a chamber changes, a ratio between oxygen taken into an aluminum film and oxygen not taken into aluminum but exhausted by a pump changes. Even after evacuation is started from the atmospheric pressure and the pressure reaches a pressure at which vapor-deposition can be performed, moisture adsorbed on a wall of a vacuum chamber gradually comes out, the adsorbed moisture decreases with time, and the pressure decreases. For this reason, oxygen is exhausted by the amount of water vapor exhausted. The water vapor reacts with aluminum to produce aluminum hydroxide. In electron beam vapor-deposition, water vapor is excited, and oxygen is partially deviated.

For this reason, the amount of oxygen taken in is lower at the end of the vapor-deposition than at the beginning of the vapor-deposition, and the light ray transmittance is higher; therefore, when the light ray transmittance is adjusted, the film thickness becomes thinner.

The moisture adsorbed on a wall of the producing apparatus varies depending on the time during which the producing apparatus is exposed to the atmosphere and humidity of the atmosphere at that time. Therefore, it is difficult to make a moisture adsorption amount at the start of vapor-deposition constant. It is difficult to obtain a long transparent barrier film having stable barrier properties in a film traveling direction (MD) and having a stable oxidation degree.

In this method, oxygen needs to be uniformly introduced in a plastic film transverse direction (TD). If there is a distribution of oxygen ejection in the TD, there is naturally a difference in oxidation degree in the TD and a difference in light ray transmittance. Since the light ray transmittance is adjusted to be uniform, as a result, the film thickness becomes non-uniform according to non-uniformity of oxygen ejection.

In the resistance heating system, the evaporation amount can be estimated to some extent, however, it is necessary to visually observe a resistance heating boat and adjust the evaporation until the evaporation is stabilized.

In addition, in the resistance heating system, immediately after the end of vapor-deposition, determination is difficult with only one film; however, a blackish brown shade is seen in appearance of a wound up roll. In the resistance heating system, heat generators made of BN composite, having a width of about 30 mm, and called boats, are generally placed at intervals of about 100 mm in the TD and vapor-deposited. It is considered that although oxygen is combined and oxidized in a process in which an evaporated gas moves from the evaporation source with spaced points to the plastic film, since a path length is different, the oxidation degree is slightly different, or the film thickness appears to be slightly shaded.

On the other hand, in the electron beam heating method using a crucible continuous in the TD, the evaporation source continuous in the TD can be obtained. Even if the film thickness fluctuates in the TD, the fluctuation is continuously gentle, and thus a shade as in the resistance heating system is not clearly seen.

PRIOR ART DOCUMENTS

PATENT DOCUMENTS

Patent Document 1: JP-B-2638797
Patent Document 2: JP-A-2007-290292
Patent Document 3: JP-A-8-60346
Patent Document 4: JP-B-4427695

SUMMARY OF THE INVENTION

PROBLEMS TO BE SOLVED BY THE INVENTION

The present invention has been devised in view of the problems of the conventional techniques. That is, an object of the present invention is to provide method and apparatus for producing transparent barrier film having a long length, stable barrier properties, and color tone by stably adjusting the oxidation degree and the film thickness to target values and producing. Furthermore, an object of the present invention to provide method and apparatus for producing a transparent barrier film having no shade when formed into a roll.

As a result of intensive studies, the present inventors have found that the above problems can be solved by the following means, and have reached the present invention. That is, the present invention has the following configurations.

A method for producing a transparent gas barrier film, the method including a step of producing a transparent gas barrier film including, on at least one surface of a plastic film, an aluminum oxide layer mainly composed of an aluminum oxide produced by evaporating metal aluminum or silicon and blowing in oxygen or a silicon oxide layer mainly composed of silicon oxide, in which in the step, a film thickness of the aluminum oxide layer formed or the silicon oxide layer formed is measured with a film thickness meter using a fluorescent X-ray, and a light ray transmittance of the aluminum oxide layer or the silicon oxide layer is measured with a light ray transmittance measurement apparatus to control the light ray transmittance to a predetermined value.

In addition, in the production method, metal aluminum or silicon is evaporated by being heated with an electron beam.

In addition, in the production method, the light ray transmittance at a wavelength of 350 nm is measured and controlled to a predetermined value.

In addition, in the production method, a light ray transmission amount of the plastic film is measured in advance before the aluminum oxide layer or the silicon oxide layer is formed, the light ray transmittance of the aluminum oxide layer alone or the silicon oxide layer alone is calculated from the light ray transmission amount of the plastic film having the aluminum oxide layer or the silicon oxide layer, and the value is controlled.

In addition, in the production method, before the aluminum oxide layer or the silicon oxide layer is formed, the plastic film is irradiated with an X-ray to measure the fluorescent X-ray serving as a background, and when the plastic film having the aluminum oxide layer or the silicon oxide layer is measured, the film thickness of the aluminum oxide layer or the silicon oxide layer is measured by correcting a thickness corresponding to the background.

An apparatus for producing a transparent gas barrier film, including: means including a step of producing a transparent gas barrier film including, on at least one surface of a plastic film, a metal oxide layer mainly composed of a metal oxide produced by evaporating metal and blowing in oxygen, and measuring, in the step, a film thickness of the aluminum oxide layer formed with a film thickness meter using a fluorescent X-ray; and means measuring a light ray transmittance of the metal oxide layer with a light ray transmittance measurement apparatus to control the light ray transmittance to a predetermined value.

EFFECT OF THE INVENTION

According to the present invention, it is possible to provide method and apparatus for producing a long transparent gas barrier film excellent in transparency and barrier properties and also excellent in appearance.

BRIEF DESCRIPTION OF THE DRAWINGS

Fig. 1 is a schematic view of a vapor-deposition apparatus.
Fig. 2 is transmittance wavelength characteristics of a plastic film and a transparent gas barrier film measured with a spectrophotometer.
Fig. 3 is a transparent gas barrier film roll produced by a conventional technique.
Fig. 4 is a transparent gas barrier film roll produced by a production method of the present invention using a producing apparatus of the present invention.

DESCRIPTION OF REFERENCE SIGNS

1: Plastic film
2: Unwinding roll
3: Plasma processing apparatus
4: Coating roll
5: Light ray transmittance measurement apparatus
6: Oxygen nozzle
7: Measurement roll
8: Fluorescent X-ray film thickness meter
9: Electron gun
10: Crucible
11: Winding roll
12: Shutter
13: Shielding plate
14: Static eliminator
15: Transmittance wavelength characteristics of plastic film (12 $\mu$m-thick PET film)
16: Transmittance wavelength characteristics of transparent gas barrier film on which aluminum oxide layer is laminated

MODE FOR CARRYING OUT THE INVENTION

Hereinafter, the present invention will be described in detail by way of example.
A method for producing a transparent gas barrier film of the present invention includes a step of producing a transparent gas barrier film including, on at least one surface of a plastic film, an aluminum oxide layer mainly composed of an aluminum oxide produced by evaporating metal aluminum or silicon and blowing in oxygen or a silicon oxide layer mainly composed of silicon oxide, in which in the step, a film thickness of the aluminum oxide layer formed or the silicon oxide layer formed is measured with a film thickness meter using a fluorescent X-ray, and a light ray transmittance of the aluminum oxide layer or the silicon oxide layer is measured with a light ray transmittance measurement apparatus to control the light ray transmittance to a predetermined value.
In the method for producing a transparent gas barrier film, a silicon oxide layer is formed using silicon monoxide or a mixture of metal silicon, silicon monoxide, and silicon dioxide as an evaporation material instead of the metal silicon.
In addition, an apparatus for producing a transparent gas barrier film of the present invention includes: means including a step of producing a transparent gas barrier film including, on at least one surface of a plastic film, a metal oxide layer mainly composed of a metal oxide produced by evaporating metal and blowing in oxygen, and measuring, in the step, a film thickness of the aluminum oxide layer formed with a film thickness meter using a fluorescent X-ray; and means measuring a light ray transmittance of the metal oxide layer with a light ray transmittance measurement apparatus to control the light ray transmittance to a predetermined value.
The plastic film used in the present invention is a plastic film obtained by melt-extruding an organic polymer, stretching the organic polymer in a machine direction and/or a transverse direction as necessary, and cooling and thermosetting the organic polymer. Examples of the organic polymer include polyethylene, polypropylene, polyethylene terephthalate, polyethylene-2,6-naphthalate, nylon 6, nylon 4, nylon 66, nylon 12, polyvinyl chloride, polyvinylidene chloride, polyvinyl alcohol, wholly aromatic polyamide, polyamide imide, polyimide, polyether imide, polysulfone, polyphenylene sulfide, and polyphenylene oxide. These organic polymers may be copolymerized or blended with a small amount of other organic polymer.
Due to global environmental problems in recent years, it is also possible to use, as an organic polymer, a recycled resin obtained by reusing polyethylene terephthalate or the like used for PET bottles or the like, or to use an organic polymer containing a part of the recycled resin. In addition, it is also possible to use an organic polymer using a part or all of an organic polymer produced by using a part or all of a biomass-derived organic substance.

Furthermore, to this organic polymer, known additives such as an ultraviolet absorber, an anti-static agent, a plasticizer, a lubricant, and a coloring agent may be added, and a plastic film having a total light ray transmittance of 70% or more is preferable from the viewpoint of the plastic film utilizing the transparency, but the degree of transparency of the plastic film is not particularly limited. The total light ray transmittance is more preferably 80% or more.

The plastic film used in the production method of the present invention may be subjected to a corona discharge treatment, a glow discharge treatment, or other surface roughening treatment before laminating an aluminum oxide layer or a silicon oxide layer thereto, or may be subjected to a known anchor coating treatment. The thickness of the plastic film used in the present invention is preferably in the range of 5 to 1000 $\mu$m, and more preferably in the range of 5 to 30 $\mu$m.

The aluminum oxide layer mainly composed of aluminum oxide in the present invention substantially contains 99% or more of aluminum oxide and other components as impurities. The aluminum oxide is not a stoichiometrically complete oxide, and is aluminum oxide that is deficient in oxygen as generally represented by AlOx (0 < x < 1.5).

Similarly, the silicon oxide layer mainly composed of silicon oxide substantially contains 99% or more of silicon oxide and other components as impurities. The silicon oxide is not a stoichiometrically complete oxide, and is silicon oxide that is deficient in oxygen as generally represented by SiOx (0 < x < 2).

In the method and apparatus for producing a transparent gas barrier film of the present invention, vapor-deposition is preferably performed by a roll-to-roll method.

As a method of producing aluminum oxide or silicon oxide from metal aluminum, metal silicon, or the like, there is a reactive sputtering method; however, a reactive vapor-deposition method is preferable from the viewpoint of a production speed.

From the viewpoint of production efficiency, it is preferable that an aluminum oxide layer or a silicon oxide layer is formed while a substrate plastic film is moved in a roll-to-roll scheme, and the light ray transmittance and the film thickness are measured to continuously produce the film.

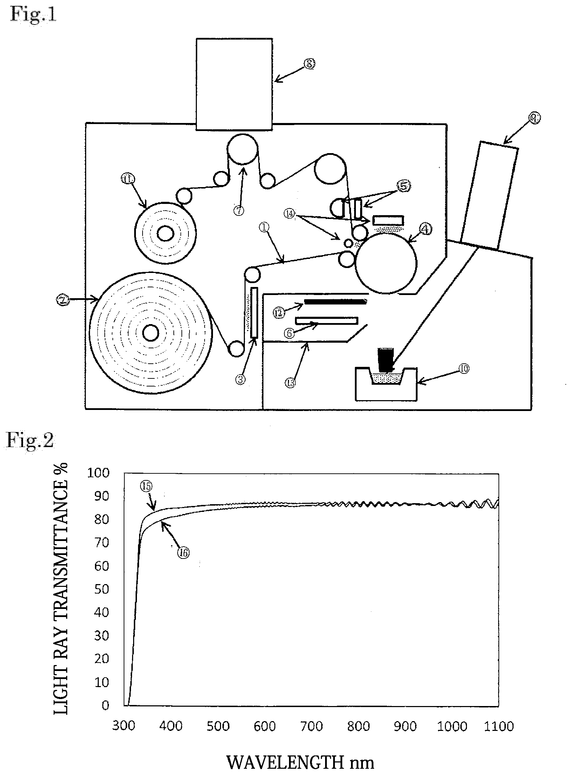

Description will be made with reference to a schematic view of an electron beam heating vapor-deposition apparatus in a roll-to-roll shown in Fig. 1. A substrate plastic film (1) is unwound from an unwinding roll (2) and treated in a plasma processing apparatus (3) in order to activate a plastic film surface. An aluminum oxide layer or a silicon oxide layer is formed while moving on a cooled coating roll (4). Static electricity charged on a transparent barrier film is removed by a static eliminator (14) and peeled off from the coating roll (4). Plastic on which the aluminum oxide layer or the silicon oxide layer is laminated passes through a light ray transmittance measurement apparatus (5) to measure the light ray transmittance. An oxidation degree is adjusted by adjusting an amount of oxygen from an oxygen nozzle (6) based on the measured value.

The film thickness of aluminum oxide or silicon oxide laminated on the plastic film moving on a measurement roll (7) is measured by a film thickness meter (8) using a fluorescent X-ray. A beam output of an electron gun (9) is adjusted based on the measured value to adjust an evaporation amount from a crucible (10). After the measurement of the film thickness, the transparent barrier film is wound around a winding roll (11). When all plastic films have been vapor-deposited, a shutter (12) is closed and stopped.

As a method of heating a vapor-deposition material, there are methods such as resistance heating, induction heating, and electron beam heating described above. Although the resistance heating system is not suitable for SiOx, the method is suitable for vapor-deposition of aluminum. Boats of approximately 30 mm in width $\times$ 100 mm in length $\times$ about 10 mm in thickness made of a material called a BN composite are arranged at intervals of 100 mm, and the boat is heated by flowing a current therethrough. When an aluminum wire having a wire shape is fed thereto, the aluminum wire in contact with the boat becomes a liquid to form a small liquid pool and evaporates. An evaporation rate can be changed by the current flowing through the boat. The aluminum wire is fed so that the liquid pool is constant.

A film thickness distribution of aluminum oxide formed on the plastic film can be adjusted by adjusting the individual evaporation rates of the boats arranged in a TD. There is an advantage that an approximate evaporation rate can be estimated from a feed rate of the aluminum wire.

However, in the resistance heating, since the aluminum wire is continuously supplied, when impurities inevitably enter and the evaporation rate is increased, bumping occurs, and liquid aluminum is blown off, so that the plastic film may be damaged. Non-uniformity of 100 mm intervals of vapor-deposition in arrangement of evaporation ranges close to points in the TD direction remains.

The induction heating system is a method in which an aluminum or silicon material is placed in a graphite crucible having a diameter of about 200 mm, and a highfrequency current is applied to a coil wound around the crucible to apply an induction current to the graphite crucible for heating. Also in this case, after arrangement in the TD, the evaporation rate and the film thickness distribution can be adjusted by individually adjusting the induction current. In the case of aluminum, since all the added materials are melted and evaporated, impurities having a low vapor pressure are evaporated first, and bumping is less likely to occur and it is excellent during a vapor-deposition process as compared with resistance heating.

However, in this method, since the material is not supplied during the vapor-deposition, the material is reduced, and an evaporation state is changed, and the evaporation amount is changed even if heating is performed with the same electric power. Although an evaporation area is larger than that in the resistance heating system, the crucible is arranged in the TD, so that small nonuniformity remains in the TD.

In the electron beam heating system, molten aluminum or the like is placed in a crucible made of a heat-resistant material such as ceramic and heated. A material sublimated from a solid such as silicon monoxide can be put in a water-cooled copper crucible and evaporated. When a crucible which is horizontally long in the TD is used, a continuous evaporation source with no cuts can be obtained. Heating is performed by scanning a vapor-deposition material surface with an electron beam using one or a plurality of electron guns. The heating can be adjusted by an output of the electron beam and a time during which the electron beam stays on the material. As compared with the resistance heating system and the induction heating system in which only an evaporation source discontinuous in the TD can be used, a continuous vapor-deposition source can be realized. In the case of vapor-depositing aluminum in the same manner as the induction heating system, since all the materials put in the crucible are dissolved and then evaporated, bumping is relatively less likely to occur.

However, even when heating is performed in the same manner as in the induction heating, it is difficult to make the evaporation amount constant because the vapor-deposition material is reduced and a heating situation changes.

When the silicon material is evaporated, since the silicon material is evaporated by sublimation other than metal silicon, aluminum that has turned into a liquid from the periphery like metal aluminum is not supplied to a heating position. Thus, it is preferable to move the crucible and supply the material.

In both the resistance heating system and the induction heating system, since the heating boat and the crucible are arranged in the TD and vapor-deposition is performed, discontinuity tends to occur in the TD due to various physical properties, or non-uniformity of height, shade, and the like tends to occur. On the other hand, in the electron beam heating system, since an evaporation source continuous in the TD can be used, smooth and uniform physical properties with respect to the TD can be easily obtained, which is preferable.

The metal aluminum of the evaporation material preferably has a purity of at least 99.5% or more in order to prevent bumping and the like. The purity is more preferably 99.99% or more.

Examples of the vapor-deposition material for silicon oxide include a silicon material obtained by mixing and sintering a powder of metal silicon, silicon monoxide, or metal silicon and silicon monoxide silicon dioxide. In the case of metal silicon, since metal silicon is melted and evaporated, a purity of 99.5% or more is required. Since silicon monoxide and a silicon material evaporate from a solid shape, it is necessary to take measures to prevent splashes in the form of powder or the like.

The plasma processing apparatus referred to in the present invention refers to an apparatus in which a DC voltage or a radio-frequency voltage (generally 13.5 MHz) is applied to a flat plate electrode, a rare gas (mainly argon gas) or oxygen is introduced to generate plasma, and the plastic film is exposed to the plasma to physically and chemically etch a surface. As a means for generating plasma, there is also a method of generating plasma by introducing microwaves. By performing plasma treatment, a plastic surface is activated, and adhesion strength with an aluminum oxide layer or a silicon oxide layer is increased or barrier performance is improved.

A coating drum referred to in the present invention is preferably cooled when the aluminum oxide layer or the silicon oxide layer is formed on the plastic film. The temperature is preferably set to 0°C or lower in order to take radiant heat from the evaporation source and heat generated when vapor-deposited particles change from gas to solid. Further, the temperature is preferably maintained at -10°C or lower, and furthermore -15°C or lower. When the temperature is -30°C or lower, an amount of heat transferred from the plastic film to the coating roll decreases, which is not preferable.

It is preferable to have a mechanism for heating the coating roll in order to quickly return the pressure to the atmospheric pressure after vapor-deposition is finished. When the coating roll is opened to the atmosphere while keeping the temperature low, dew formation occurs on the coating roll, the plastic film becomes wet, and the subsequent evacuation is affected.

The light ray transmittance measurement apparatus referred to in the present invention refers to an apparatus in which a light emitter is installed on one side of a film and a photodetector that receives light transmitted through the film is installed on the opposite side. Examples of the photodetector include a photoresistor and a photodiode using a photoelectric tube or a semiconductor, and the photoresistor and the photodiode are preferable from the viewpoint of downsizing. Examples of the light emitter include light bulbs such as halogen lamps, and LEDs (light emitting diodes) having a small size and a long life are preferable.

Fig. 2 shows the transmittance wavelength characteristics of a transparent gas barrier film (16) obtained by laminating a plastic film (15) and an aluminum oxide layer measured with a spectrophotometer. There is a significant difference in transmittance between the plastic film and the transparent gas barrier film in which the aluminum oxide layer is laminated around a wavelength centered at 350 nm. Therefore, a light ray transmittance measurement apparatus that measures the light ray transmittance centered at 350 nm is preferable.

As a method of measuring the light ray transmittance centered at 350 nm, there are a method of using a light emitter that emits light around 350 nm and a method of receiving light around 350 nm. As the method of emitting light around 350 nm, there is a method of narrowing the wavelength using a filter in a lamp that strongly emits an ultraviolet ray such as a xenon lamp, or a method of using an LED having an emission wavelength around 350 nm. As the method of receiving light, there is a method of installing a filter that transmits only light around 350 nm in front of the photodetector; however, from the viewpoint of efficiency and ease of handling, a method using an LED having an emission wavelength around 350 nm is preferable.

When a light ray transmission amount of only the plastic film is measured in advance in the light ray transmittance measurement apparatus and the light ray transmission amount of the transparent barrier film is measured, it is preferable to calculate and output the light ray transmittance of the aluminum oxide layer or the silicon oxide layer using the light ray transmission amount of only the plastic film.

As a measurement section of the light ray transmittance measurement apparatus, a plurality of measurement sections arranged in the TD of the plastic film are preferably used. The oxidation degree can be more uniformly adjusted when the measurement sections are arranged at intervals of 100 mm.

A fluorescent X-ray film thickness meter referred to in the present invention measures the film thickness by irradiating a transparent barrier film to be measured with an X-ray generated by an X-ray tube and measuring intensity of a fluorescent X-ray generated by exciting an aluminum atom of an aluminum oxide layer or a silicon atom of a silicon oxide layer.

As a method of spectrally dispersing the generated fluorescent X-ray, there are an energy dispersion method and a wavelength dispersion method. Although the energy dispersion method is good because it can be miniaturized, the resolution is inferior to that of the wavelength dispersion method. The wavelength dispersion method is advantageous when there are influences of other elements.

In the measurement using the fluorescent X-ray, it is important to stabilize a distance between a detection target and a detector. Therefore, when a thin object such as a plastic film moves at a high speed, the film becomes unstable due to wrinkles or vibration, and thus it is preferable to perform measurement on a measurement roll as shown in Fig. 1. The material of the measurement roll is preferably a material containing no aluminum or silicon from the viewpoint of measuring the aluminum oxide layer or the silicon oxide layer.

In the measurement using the fluorescent X-ray, it is preferable that the distance between the detector and the plastic film to be measured is set to a short distance because sensitivity increases. For example, it is preferable that a lower portion of the fluorescent X-ray film thickness meter and the measurement roll are brought close to each other so that a distance therebetween is about 1 to 5 mm. When the distance is 1 mm or less, there is a risk of contact and breakage due to foreign matter or vibration during measurement. When replacement of the plastic film, cleaning of the roll, maintenance of the fluorescent X-ray film thickness meter, or the like is performed, it is difficult to perform the operation if a space between the measurement roll and the fluorescent X-ray film thickness meter is narrow. It is preferable to provide a mechanism for increasing the distance between the measurement roll and the fluorescent X-ray film thickness meter. In this case, although each position of the fluorescent X-ray film thickness meter and the measurement roll is returned to an original position after the operation is finished, it is difficult to make the distance between the fluorescent X-ray film thickness meter and the measurement roll completely coincide with each other; therefore, it is preferable to provide a mechanism for measuring the distance between the fluorescent X-ray film thickness meter and the measurement roll to correct X-ray intensity.

Since the sensitivity and spectral performance of the detector for fluorescent X-rays are affected by temperature, it is preferable to provide a mechanism for making the sensitivity and the spectral performance constant. In addition, it is preferable to have a mechanism for correcting the X-ray intensity by measuring the temperature with respect to some fluctuations.

In the fluorescent X-ray film thickness meter, when the X-ray tube that excites the fluorescent X-ray is deteriorated with time to change the intensity of the excited X-ray, or when a crystal used for spectroscopy is deteriorated in the wavelength dispersion method, or when an X-ray detector is deteriorated, fluorescent X-ray intensity to be measured varies. Thus, it is preferable to include a calibration plate for calibrating the X-ray intensity.

The calibration plate preferably generates a fluorescent X-ray having an intensity close to the fluorescent X-ray intensity generated by the transparent barrier film to be measured, and does not deteriorate over time. It is more preferable to include two types of calibration plates (for example, a plate in which an aluminum oxide layer is laminated on a metal plate such as titanium) having different fluorescent X-ray intensities.

The calibration plate is associated with the fluorescent X-ray film thickness meter, and the fluorescent X-ray intensity ($I_1$, $I_2$) is measured by applying the X-ray before starting the film thickness measurement. It is preferable that the measured fluorescent X-ray intensity is compared with a reference fluorescent X-ray intensity ($I_{01}$, $I_{02}$) of the calibration plate measured when a calculation formula for converting from the fluorescent X-ray intensity to the film thickness is determined, a function for correcting the X-ray intensity is created, and the fluorescent X-ray intensity ($I$) observed when the film thickness is measured is corrected.

For example, when there are two types of calibration plates, the correction can be expressed by Formula 1 when the corrected fluorescent X-ray intensity ($I'$) is used.

$$I' = \alpha I + \beta \quad - \text{(Formula 1)}$$

$$\alpha = (I_{01} - I_{02})/(I_1 - I_2)$$

$$\beta = (I_1 I_{02} - I_2 I_{01})/(I_1 - I_2)$$

$I'$: Corrected fluorescent X-ray intensity
$I$: Fluorescent X-ray intensity before correction
$I_{01}$: Reference fluorescent X-ray intensity of calibration plate 1
$I_{02}$: Reference fluorescent X-ray intensity of calibration plate 2
$I_1$: Measured fluorescent X-ray intensity of calibration plate 1
$I_2$: Measured fluorescent X-ray intensity of calibration plate 2

The fluorescent X-ray film thickness meter referred to in the present invention preferably has a function of correcting the fluorescent X-rays from a web and the roll. In general, fine particles of silicon dioxide as a lubricant are added to the plastic film so that the plastic films slide with each other to form unevenness on the surface. The measurement roll is also contaminated with vapor-deposition scraps or the like when used for a long time. It is preferable to have a correction function in order to correct the fluorescent X-ray from the lubricant and dirt. In a method of correcting the fluorescent X-ray from the web and the roll, the fluorescent X-ray intensity of only the plastic film is measured before the aluminum oxide layer or the silicon oxide layer is formed, the above correction is performed and then stored, and the fluorescent X-ray intensity measured when the film thickness of the transparent barrier film on which the aluminum oxide layer and the silicon oxide layer are formed is measured is corrected by self-consistency in consideration of the X-ray absorption in the aluminum oxide layer or the silicon oxide layer.

The correction by self-consistency means that calculation is performed on the assumption that the fluorescent X-ray intensity at the time of only the plastic film measured in advance reaches the film thickness meter with the intensity obtained by adding the intensity absorbed and leaked by the aluminum oxide layer or the silicon oxide layer and the fluorescent X-ray intensity generated from the aluminum oxide layer or the silicon oxide layer, and the absorption of the X-ray at the film thickness of the aluminum oxide layer or the silicon oxide layer and the generated X-ray from the film thickness do not contradict each other.

By this correction, the fluorescent X-ray intensity from only the aluminum oxide layer or the silicon oxide layer is obtained.

The fluorescent X-ray film thickness meter referred to in the present invention has a film thickness conversion function from the fluorescent X-ray intensity. As a method of converting the fluorescent X-ray intensity into the film thickness by a fluorescent X-ray method, there are a calibration curve method and a fundamental parameter method (FP method).

From the viewpoint of accuracy, it is preferable to obtain by the calibration curve method.

For a standard sample used for preparing the calibration curve, an amount of adhesion per unit area of the aluminum oxide layer or the silicon oxide layer on the plastic film is determined in advance using inductively coupled plasma emission spectrometry or the like. The amount of adhesion is converted to obtain the film thickness. In the case of aluminum oxide, the film thickness was calculated assuming that the density was 0.74 times ($2.94 \text{ g/cm}^3$) a bulk density ($3.97 \text{ g/cm}^3$), and was defined as the film thickness of the standard sample. Similarly, in the case of silicon oxide, the film thickness was calculated assuming that the density was 0.74 times ($1.96 \text{ g/cm}^3$) the bulk density ($2.65 \text{ g/cm}^3$). The reason why the density is 0.74 times the bulk density is that the film thickness is well matched with an actual film thickness obtained by TEM or the like.

As a measurement section of the fluorescent X-ray film thickness meter, a plurality of measurement sections arranged in the TD of the plastic film are preferably used. The interval between at least the measurement sections is preferably 500 mm or less.

Since the measurement section of the fluorescent X-ray film thickness meter is relatively large, the measurement section may be disposed in a staggered manner with respect to a straight line without being disposed on the straight line in the TD. In this case, the interval between the measuring sections refers to a shortest distance of a straight line or a curve of a locus drawn by a center of gravity of a spot range measured by at least two monitors as the plastic film moves in the MD.

As a method of adjusting the evaporation amount from the measured film thickness to obtain a target film thickness according to the present invention, a known method can be used; however, a method of controlling while estimating the film thickness between the measurement sections is preferable (see, for example, Patent Document 4) .

The method of adjusting the oxidation degree according to the present invention is performed by adjusting the amount of oxygen introduced from the nozzle.

Although aluminum oxide or silicon oxide is a complete oxide and colorless, light absorption occurs due to oxygen defects. When a light absorption coefficient is $\alpha_0$, the light absorption coefficient is associated with a light ray transmittance $T_1$ by Formulas 2 and 3.

$$I_1 = I_{10} \times EXP\ (-\alpha_0 \bullet t)\quad - \text{(Formula 2)}$$

$$T_1 = I_1/I_{10} \times 100\quad - \text{(Formula 3)}$$

$I_1$: Transmitted light amount of transparent gas barrier film
$I_{10}$: Light ray transmission amount of plastic film of web of transparent gas barrier film
$\alpha_0$: Absorption coefficient of aluminum oxide layer or silicon oxide layer
t: Film thickness of aluminum oxide layer or silicon oxide layer
$T_1$: Light ray transmittance of aluminum oxide layer or silicon oxide layer

The oxidation degree of the aluminum oxide layer or the silicon oxide layer is associated with the absorption coefficient. Therefore, the light ray transmittance is measured by clarifying the film thickness of aluminum oxide or silicon oxide, and the oxidation degree can be controlled by adjusting the light ray transmittance.

The light ray transmission amount referred to in the present invention is a value measured by the light ray transmittance measurement apparatus. That is, the value is a value that is output when light from the light emitter is received by the light detector installed on one side of the plastic film and installed on the opposite side through the plastic film.

As shown in Fig. 2, in the aluminum oxide layer, light absorption due to insufficient oxidation becomes remarkable around 350 nm, so that it is preferable to use the light ray transmittance around 350 nm in order to adjust the oxidation degree.

As the method of adjusting the oxidation degree of aluminum oxide and silicon oxide according to the present invention, the light ray transmittance is adjusted by adjusting the amount of oxygen introduced from the oxygen nozzle while adjusting the film thickness to a target film thickness with the fluorescent X-ray film thickness meter.

A part of oxygen supplied is consumed by being combined with aluminum, and a part thereof is exhausted by a pump. As the position of the pump, the pump is not disposed as an object with respect to the MD, and therefore, even if oxygen is uniformly supplied in the TD, the oxidation degree in the TD of aluminum oxide and silicon oxide is not uniform. Thus, a method of supplying oxygen to aluminum or silicon needs to take this into consideration.

The oxygen nozzle referred to in the present invention is preferably a method capable of supplying oxygen so that oxidation becomes uniform in the TD. For example, when a hole in which a long pipe is disposed in the TD and conductance is adjusted at appropriate intervals, for example, a hole with an appropriate size is formed and used as a nozzle, oxygen distribution can be adjusted to supply oxygen in the TD. On the other hand, the oxygen distribution can be adjusted in the TD by providing an elongated slit instead of the hole and adjusting an opening width. A mass flow controller is connected to the pipe, and oxygen supplied to the pipe can be adjusted to adjust the oxidation degree.

In addition, as a method of actively adjusting distribution of the oxidation degree in the TD, the nozzle is arranged in the TD, the mass flow controller is attached thereto, the amount of oxygen supplied from the nozzle is adjusted, and the light ray transmittance can be adjusted in the TD to adjust the oxidation degree.

As a position where the oxygen nozzle is installed according to the present invention, the oxygen nozzle can be installed at any position; however, it is preferable to install the oxygen nozzle so that a large amount of oxygen does not go to the evaporation source. This is because when a large amount of oxygen goes to the evaporation source, the material of the vapor-deposition source is oxidized, and an evaporation temperature increases.

It is preferable to install the oxygen nozzle at an intermediate position between the crucible and the coating roll or in the vicinity of the coating roll.

Vaporized particles adhere to an outlet of the oxygen nozzle, and a gas flow changes. Alternatively, it is preferable to provide a shielding plate so that the outlet is blocked and a flow rate does not change.

Note that the present invention is not limited to the embodiments described above, and various modifications can be made as long as the gist of the present invention is not impaired.

For example, the example in which the film thickness is measured with the fluorescent X-ray film thickness meter after the light ray transmittance is measured by the light ray transmittance measurement apparatus has been described; however, the light ray transmittance measurement apparatus that measures the light ray transmittance with the light ray transmittance measurement apparatus after the film thickness is measured with the fluorescent X-ray film thickness meter may be disposed to be installed. The plasma processing apparatus may be omitted.

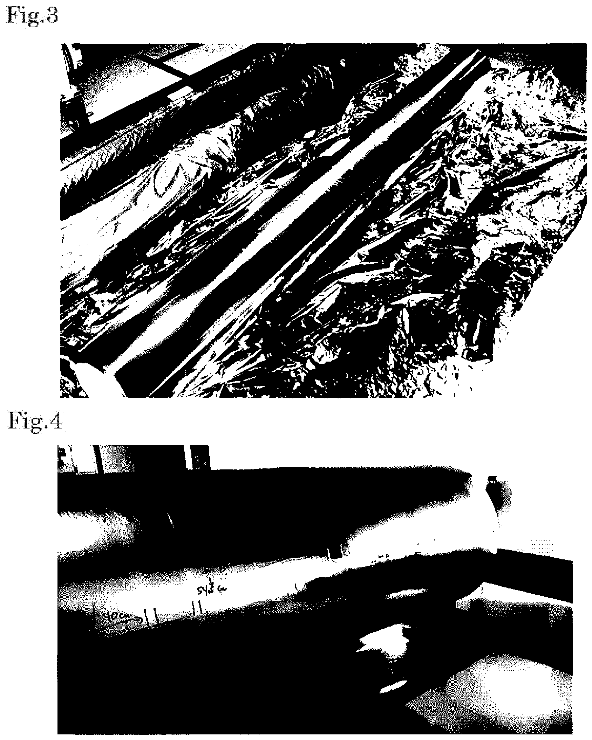

Fig. 3 shows a transparent gas barrier film roll produced by a conventional technique, and Fig. 4 shows a transparent gas barrier film roll produced by the production method of the present invention using the producing apparatus of the present invention. Although the transparent gas barrier film roll of Fig. 3 has a blackish brown shade in the transverse direction, the transparent gas barrier film roll of Fig. 4 has almost no shade.

INDUSTRIAL APPLICABILITY

According to the present invention, it is possible to provide method and apparatus for producing a transparent barrier film having excellent appearance and barrier properties by stably adjusting the film thickness and oxidation degree of a barrier layer to target values in a step of producing a transparent barrier film by evaporating metal aluminum or a silicon material and introducing oxygen to form an aluminum oxide layer or a silicon oxide layer on a plastic film.

**Claims**

1.  A method for producing a transparent gas barrier film, the method comprising a step of producing a transparent gas barrier film including, on at least one surface of a plastic film, an aluminum oxide layer mainly composed of an aluminum oxide produced by evaporating metal aluminum or silicon and blowing in oxygen or a silicon oxide layer mainly composed of silicon oxide, wherein in the step, a film thickness of the aluminum oxide layer formed or the silicon oxide layer formed is measured with a film thickness meter using a fluorescent X-ray, and a light ray transmittance of the aluminum oxide layer or the silicon oxide layer is measured with a light ray transmittance measurement apparatus to control the light ray transmittance to a predetermined value.

2.  The method for producing a transparent gas barrier film according to claim 1, wherein metal aluminum or silicon is evaporated by being heated with an electron beam.

3.  The method for producing a transparent gas barrier film according to claim 1 or 2, wherein the light ray transmittance at a wavelength of 350 nm is measured and controlled to a predetermined value.

4.  The method for producing a transparent gas barrier film according to any one of claims 1 to 3, wherein a light ray transmission amount of the plastic film is measured in advance before the aluminum oxide layer or the silicon oxide layer is formed, the light ray transmittance of the aluminum oxide layer alone or the silicon oxide layer alone is calculated from the light ray transmission amount of the plastic film having the aluminum oxide layer or the silicon oxide layer, and the value is controlled.

5.  A method for producing a transparent gas barrier film, the method comprising:

    irradiating a plastic film with an X-ray to measure a fluorescent X-ray serving as a background before forming an aluminum oxide layer or a silicon oxide layer; and
    measuring a film thickness of the aluminum oxide layer or the silicon oxide layer by correcting a thickness corresponding to the background when the plastic film having the aluminum oxide layer or the silicon oxide layer is measured.

6.  An apparatus for producing a transparent gas barrier film, comprising:

    means including a step of producing a transparent gas barrier film including, on at least one surface of a plastic film, a metal oxide layer mainly composed of a metal oxide produced by evaporating metal and blowing in oxygen, and measuring, in the step, a film thickness of the aluminum oxide layer formed with a film thickness meter using a fluorescent X-ray; and
    means measuring a light ray transmittance of the metal oxide layer with a light ray transmittance measurement apparatus to control the light ray transmittance to a predetermined value.

Fig.1

Fig.2

Fig.3

Fig.4

# EP 4 257 722 A1

## INTERNATIONAL SEARCH REPORT

International application No.

**PCT/JP2021/043002**

### A. CLASSIFICATION OF SUBJECT MATTER

*C23C 14/24*(2006.01)i; *B32B 9/00*(2006.01)i; *C23C 14/08*(2006.01)i
FI:  C23C14/24 U; B32B9/00 A; C23C14/08 A; C23C14/08 J

According to International Patent Classification (IPC) or to both national classification and IPC

### B. FIELDS SEARCHED

Minimum documentation searched (classification system followed by classification symbols)

C23C14/24; B32B9/00; C23C14/08

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | WO 2019/031262 A1 (TOYOBO CO., LTD.) 14 February 2019 (2019-02-14)<br>paragraphs [0043]-[0053], fig. 1 | 1-6 |
| Y | JP 2001-192810 A (JAPAN VACUUM ENGINEERING CO., LTD.) 17 July 2001 (2001-07-17)<br>paragraphs [0024]-[0030], fig. 1, 2 | 1-6 |
| Y | JP 2007-290291 A (DAINIPPON PRINTING CO LTD) 08 November 2007 (2007-11-08)<br>paragraphs [0014], [0030], fig. 2 | 1-6 |
| A | JP 2003-105527 A (TOHCELLO CO LTD) 09 April 2003 (2003-04-09)<br>entire text | 1-6 |
| A | JP 05-339704 A (TORAY IND INC) 21 December 1993 (1993-12-21)<br>entire text | 1-6 |
| A | JP 10-330915 A (REIKO CO LTD) 15 December 1998 (1998-12-15)<br>entire text | 1-6 |

| ☑ | Further documents are listed in the continuation of Box C. | ☑ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **17 January 2022** | **01 February 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

| | International application No. |
|---|---|
| | **PCT/JP2021/043002** |

| C. | DOCUMENTS CONSIDERED TO BE RELEVANT |
|---|---|

| Category* | Citation of document, with indication, where appropriate, of the relevant passages | Relevant to claim No. |
|---|---|---|
| P, X | WO 2020/241621 A1 (TOYOBO CO., LTD.) 03 December 2020 (2020-12-03) paragraph [0033] | 1, 2, 6 |
| P, A | | 3-5 |

Form PCT/ISA/210 (second sheet) (January 2015)

**INTERNATIONAL SEARCH REPORT**
Information on patent family members

International application No.

**PCT/JP2021/043002**

| Patent document cited in search report | | | Publication date (day/month/year) | Patent family member(s) | | | Publication date (day/month/year) |
|---|---|---|---|---|---|---|---|
| WO | 2019/031262 | A1 | 14 February 2019 | US 2020/0248298 A1 paragraphs [0047]-[0066], fig. 1 | | | |
| | | | | EP 3666922 A1 | | | |
| | | | | KR 10-2020-0039717 A | | | |
| | | | | CN 111133124 A | | | |
| | | | | CA 3072149 A | | | |
| | | | | TW 201910540 A | | | |
| JP | 2001-192810 | A | 17 July 2001 | (Family: none) | | | |
| JP | 2007-290291 | A | 08 November 2007 | (Family: none) | | | |
| JP | 2003-105527 | A | 09 April 2003 | EP 1298229 A1 entire text | | | |
| | | | | KR 10-2003-0026879 A | | | |
| | | | | CN 1408896 A | | | |
| | | | | TW I293091 B | | | |
| JP | 05-339704 | A | 21 December 1993 | (Family: none) | | | |
| JP | 10-330915 | A | 15 December 1998 | (Family: none) | | | |
| WO | 2020/241621 | A1 | 03 December 2020 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2638797 B
- JP 2007290292 A
- JP 8060346 A
- JP 4427695 B